# EUROPÄISCHE PATENTSCHRIFT

(11) **EP 1 885 895 B1**
(45) Veröffentlichungstag und Bekanntmachung des Hinweises auf die Patenterteilung: **18.08.2010**
(21) Anmeldenummer: 06753596.3
(22) Anmeldetag: 13.05.2006
(51) Int. Cl.: C22C 9/06, C22F 1/08, F16C 33/12

(54) **GLEITLAGERVERBUNDWERKSTOFF, VERWENDUNG UND HERSTELLUNGSVERFAHREN**
PLAIN BEARING COMPOSITE MATERIAL, USE THEREOF AND PRODUCTION METHODS THEREFOR
MATERIAU COMPOSITE POUR PALIERS LISSES, UTILISATION ET PROCEDE DE PRODUCTION

(30) Priorität: 13.05.2005 DE 102005023307
(43) Veröffentlichungstag der Anmeldung: 13.02.2008
(73) Patentinhaber: Federal-Mogul Wiesbaden GmbH, 65201 Wiesbaden (DE)
(72) Erfinder: WILHELM, Maik, 55270 Ober-Olm (DE); LEHMANN, Uwe, 55232 Alzey (DE); ANDLER, Gerd, 65307 Bad Schwalbach (DE); DAMOUR, Philippe, 60489 Frankfurt/Main (DE); GRAHAM, Neil, 65189 Wiesbaden (DE)
(74) Vertreter: Fuchs
(86) Internationale Anmeldenummer: PCT/EP2006/004515
(87) Internationale Veröffentlichungsnummer: WO 2006/120022

(56) Entgegenhaltungen:
- DE-C1- 4 415 629
- US-A1- 2003 209 103

## Beschreibung

Die Erfindung betrifft einen Gleitlagerverbundwerkstoff gemäß Anspruch 1. Ferner bezieht sich die Erfindung auf eine Verwendung und auf Herstellungsverfahren.

Aus der DE 44 15 629 C1 ist die Verwendung einer Kupfer-Nickel-Siliziumlegierung für die Herstellung von verschleißfesten Gegenständen mit Notlaufeigenschaften, wie beispielsweise Gießkolben von Druckgießmaschinen bekannt. Die in der DE 44 15 629 C1 beschriebene Legierung besteht aus 1 - 4% Nickel, 0,1 -1,5% Silizium und Rest Kupfer und wird als Massivwerkstoff eingesetzt.

Die US 2,137,282 beschreibt eine Legierung aus 0,1 - 30% Nickel, 0,05 - 3% Silizium und Rest Kupfer. Diese Legierung zeichnet sich nach entsprechender Wärmebehandlung durch große Härten und gute elektrische Leitfähigkeiten aus.

Die US 1,658,186 beschreibt eine Kupfer-Nickel-Siliziumlegierung, wobei ausführlich die als Hartteilchen wirkenden Silizide diskutiert werden. Verschiedene Wärmebehandlungsverfahren zur Einstellung der Härte werden angegeben.

Eine weitere Kupfer-Nickel-Siliziumlegierung findet sich in US 2,241,815, wobei der Nickelanteil bei 0,5 - 5% und der Siliziumanteil bei 0,1 - 2% liegt.

Die US 2,185,958 beschreibt Legierungen aus 1 % Nickel, 3,5% Silizium und Rest Kupfer sowie aus 1,5% Silizium und 1% Nickel sowie Rest Kupfer.

Aus der DE 36 42 825 C1 ist ein Gleitlagerwerkstoff bestehend aus 4 bis 10% Nickel, 1 - 2% Aluminium, 1 - 3% Zinn und Rest Kupfer sowie übliche Verunreinigungen bekannt, der eine hohe Festigkeit und große Lebensdauer aufweisen soll. Aus diesem Gleitlagerwerkstoff werden Vollmaterialbuchsen hergestellt.

Die GB 2384007 beschreibt einen Gleitlagerverbundwerkstoff mit einem Stahlrücken, auf dem eine Sinterschicht aus einer Kupferlegierung aufgebracht ist, die eine Härte von max. 130 HV aufweist. Die Kupferlegierung weist 1 - 11 Gew.% Zinn, bis 0,2 Gew.% Phosphor, max. 10 Gew.% Nickel oder Silber, max. 25 Gew.% Blei und Wismut auf.

Gleitlagerverbundwerkstoffe bei denen eine Gleitschicht auf eine Lagermetallschicht aufgesputtert ist, sind mit Zwischenschichten aus Nickel, aus einer Nickellegierung, aus Nickel-Chrom, aus Zink oder aus einer Zinklegierung versehen, wie dies in DE 43 28 921 A1 beschrieben wird. Wenn eine Cu-Legierung als Lagerlegierung verwendet wird, und wenn eine Sn-enthaltende Legierung für die oberste Schicht verwendet wird, dann diffundiert das Sn im Verlauf der Zeit in die Cu-Legierung hinein, wodurch der Sn-Gehalt der obersten Schicht verringert wird. Zur gleichen Zeit wird eine brüchige CuSn-Verbindung an der Verbindungsoberfläche erzeugt, wodurch die Bindungsfestigkeit erniedrigt wird. Im Hinblick darauf wird die Zwischenschicht aus Ni oder einer Ni-Legierung auf der Lagerlegierung durch Aufspritzen bzw. Aufsprühen oder durch Elektroplattieren gebildet. Darauf wird dann durch Dampfabscheidung die oberste Schicht gebildet, wodurch eine stabilere Bindung erhalten werden kann.

Diffusionssperrschichten werden auch in der DE 28 53 774 erwähnt.

Die DE 195 25 330 beschreibt einen Schichtwerkstoff, bei dem unmittelbar auf einen Trägerwerkstoff ein Lagerwerkstoff aufgesputtert wird. Als Trägerwerkstoff kann ein Stahlstützmetall verwendet werden, auf das der Lagerwerkstoff ohne weitere Zwischenschicht aufgebracht werden kann. Es besteht aber auch die Möglichkeit, als Trägerwerkstoff einen kupferhaltigen, insbesondere einen Trägerwerkstoff aus einer Kupfer-Blei-Zinn-Legierung zu verwenden. Beispielsweise kann der Trägerwerkstoff aus CuPb22Sn bestehen.

Wenn der Bleianteil des Trägerwerkstoffes in der Größenordnung des Bleianteils des Lagerwerkstoffes liegt, besteht zwischen beiden Materialien kein oder nur ein geringes Konzentrationsgefälle, so dass auch keine Diffusionsvorgänge zwischen dem Lagerwerkstoff und dem Trägerwerkstoff stattfinden können. Wenn der Trägerwerkstoff eine höhere Bleikonzentration als der Lagerwerkstoff aufweist, wird die Abwanderung des Bleis an die Oberfläche des Lagerwerkstoffes zusätzlich begünstigt. Die Kupfer-Blei-Zinn-Legierung, die den Trägerwerkstoff bildet, kann auf ein Stahlstützmetall gießplattiert sein.

Aufgabe der Erfindung ist es, einen Gleitlagerverbundwerkstoff mit aufgesputterten Gleitschichten zur Verfügung zu stellen, der hinsichtlich seiner Festigkeits- und tribologischen Eigenschaften mit den bekannten Verbundwerkstoffen vergleichbar ist, wobei unabhängig von der Zusammensetzung der Gleitschicht auf Diffusionssperrschichten verzichtet werden kann. Es ist auch Aufgabe, eine Verwendung und Herstellungsverfahren anzugeben.

Diese Aufgabe wird mit einem Gleitlagerverbundwerkstoff gemäß Patentanspruch 1 gelöst.

Es hat sich herausgestellt, dass bei den beanspruchten Kupferlegierungen mit Nickel- und Siliziumanteilen diese Komponenten diffusionshemmend, insbesondere auf Aluminium und Zinn einwirken, so dass es fast nicht zu einer Diffusion kommt. Eine geringe Diffusion kann nie ausgeschlossen werden, es bildet sich hierbei aber nur eine extrem dünne Zwischenschicht aus, die nicht zu einer Ablösung der auf der Kupferlegierung aufgebrachten Gleitschicht führt.

Weitere Vorteile dieser Kupferlegierungen bestehen darin, dass sie sich hinsichtlich ihrer Gefüge und damit ihrer mechanischen Eigenschaften in einem weiten Bereich einstellen lassen. Es ist daher möglich, die Festigkeit und die mechanischen Eigenschaften so einzustellen, dass die Kupferlegierung die Funktion des Stahlrückens übernimmt, der damit entfallen kann. Gleichzeitig besitzen diese Kupferlegierungen trotz der erforderlichen Festigkeit hervorragende Dämpfungseigenschaften.

Die Herstellung des Gleitlagerelementes aus einem solchen Gleitlagerverbundwerkstoff wird aufgrund des Verzichts des Stahlrückens vereinfacht und somit kostengünstiger.

Als besonders vorteilhaft für den Einsatz als Gleitlager für hochbelastete Motoren hat sich bei diesen Legierungen das günstige Verhältnis aus E-Modul und einstellbarer Festigkeit erwiesen.

Ein weiterer Vorteil besteht darin, dass die thermischen Ausdehnungskoeffizienten der Kupferlegierungen in der Größenordnung der thermischen Ausdehnungskoeffizienten für Aluminium liegen, so dass Gleitlagerschalen aus dem erfindungsgemäßen Verbundmaterial vorzugsweise in Aluminiumgehäusen eingesetzt werden können. Bei hohen Temperaturen ist deshalb nach wie vor ein guter Presssitz gewährleistet.

Die Einstellung der Festigkeit der Kupferlegierung erfolgt vorzugsweise durch eine thermomechanische Behandlung, insbesondere durch Walzen und Glühen.

Das erfindungsgemäße Herstellungsverfahren von Bandmaterial für den Gleitlagerverbundwerkstoff sieht folgende Verfahrensschritte vor:
Herstellen von Bandmaterial aus einer Kupfer-Nickel-Silizium-Legierung mit anschließender thermomechanischer Behandlung mit folgenden Schritten:
   erstes Glühen des Bandmaterials bei Temperaturen größer 500°C für mindestens 3 Stunden, mindestens ein erstes Walzen des Bandmaterials, wobei ein Umformgrad von mindestens 20 % durchgeführt wird, mindestens ein zweites Glühen bei Temperaturen größer 500°C, und mindestens ein zweites Walzen des Bandmaterials, wobei ein Umformgrad von größer 30 % durchgeführt wird.

Vorzugsweise wird das zweite Glühen kontinuierlich in einer Bandglühanlage mit einer Vorschubgeschwindigkeit des Bandes von mindestens 3 m/min, insbesondere von 3 - 5 m/min bei Temperaturen >500°C durchgeführt.

Mittels des zweiten Walzschrittes wird die Festigkeit des Bandmaterials eingestellt, wobei vorzugsweise Zugfestigkeitswerte von 550 bis 750 MPa realisiert werden.

Das Gefüge nach der thermo-mechanischen Behandlung zeichnet sich durch eine zeilenförmige Matrixstruktur aus, wobei innerhalb dieser Zeilenstruktur feine, gleichmäßig verteilte intermetallische Ausscheidungen auf NiSi-Basis vorliegen.

Die genannten Zugfestigkeitswerte liegen deutlich über denen vom Stahl des Stahlverbundwerkstoffes, der sich bereits bei geringerer Belastung plastisch verformen würde, was zu einer Spielzunahme des aus dem Verbundlagerwerkstoff hergestellten Gleitlagers und zu einem Verlust der Dämpfungseigenschaften führt. Der Vorteil der erfindungsgemäßen Kupferlegierungen besteht darin, dass die Streckgrenze soweit angehoben werden kann, dass bei hoher Lagerbelastung die elastischen Eigenschaften beibehalten werden können.

In der Regel ist die Dicke des Ausgangsbandmaterials sowie die Enddicke des Bandmaterials vorgegeben. Um unterschiedliche Festigkeitswerte erhalten zu können, wird daher vorzugsweise das erstmalige Walzen mit solchen Umformgraden durchgeführt, dass sich beim zweiten Walzen die gewünschten Festigkeitswerte einstellen. Dies bedeutet, dass beispielsweise zur Erreichung hoher Festigkeitswerte beim ersten Walzen nur eine geringe Dickenreduktion durchgeführt wird, während für niedrige Festigkeitswerte bereits beim ersten Walzen hohe Umformgrade erreicht werden.

Vom Bandmaterial werden zur Herstellung von Gleitlagerelementen nach dem Längsteilen des Bandes Platinen abgetrennt und die Platinen durch bekannte Umformschritte zu Gleitlagerelementen umgeformt. Der abschließende Prozess stellt das Gleitflächenbearbeiten und das Aufbringen der Gleitschicht dar.

Die Gleitschicht wird mittels eines PVD-Verfahrens, insbesondere mittels Sputtern, aufgetragen. Gegebenenfalls wird auf die Gleitschicht noch eine Einlaufschicht aufgebracht.

Durch die Gleitschicht werden die tribologischen Eigenschaften des Verbundwerkstoffs eingestellt.

In der Kupfer-Nickel-Siliziumlegierung liegt der Nickelanteil bei 0,5 - 5 Gew.%, vorzugsweise bei 1,0 bis 3,0 Gew.%, insbesondere bei 1,5 bis 2,2 Gew.%, und der Siliziumanteil bei 0,2 - 2,5 Gew.%, vorzugsweise bei 0,4 bis 1,2 Gew.%, oder bei 0,5 bis 1,5 Gew.%.

Die Kupfer-Nickel-Silizium-Legierung kann 0,05 - 2,0 Gew.% Mangan, vorzugsweise 0,15 - 1,5 Gew.% aufweisen.

Es hat sich gezeigt, dass bei einem Gewichtsverhältnis von Nickel zu Silizium zwischen 2,5 und 5 (Nickel : Silizium = 2,5 bis 5) die tribologischen Eigenschaften verbessert werden können, insbesondere ein Fressen des Lagerwerkstoffes deutlich verringert werden kann. Bei diesen Gewichtsverhältnissen werden die für die guten tribologischen Eigenschaften verantwortlichen Nickel-Silizium-Verbindungen begünstigt und in ausreichendem Maße gebildet.

Die Kupferlegierungen können weitere Mikrolegierungselemente aufweisen. Vorzugsweise weist die Trägerschicht 0,05 - 0,4 Gew.%, vorzugsweise 0,075 bis 0,25 Gew.%, mindestens eines Mikrolegierungselementes auf. Als Mikrolegierungselemente kommen beispielsweise Chrom, Titan, Zirkon, Zink und Magnesium einzeln oder in Kombination in Frage.

Sputter-Schichten bestehen vorzugsweise aus einer Aluminium-Zinn-Legierung, Aluminium-Zinn-Silizium-Legierung, Aluminium-Zinn-Kupfer-Legierung, einer Aluminium-Zinn-Silizium-Kupfer-Legierung oder einer Aluminium-Zinn-Nickel-Mangan-Legierung besteht.

Vorzugsweise beträgt in diesen Legierungen der Zinnanteil 8 - 40 Gew.%, der Kupferanteil 0,5 - 4,0 Gew.%, der Siliziumanteil 0,02 - 5,0 Gew.%, der Nickelanteil 0,02 - 2,0 Gew.% und der Mangananteil 0,02 - 2,5 Gew.%.

Es hat sich gezeigt, dass sich mit diesen Sputter-Schichten in Kombination mit den beanspruchten Kupferlegierungen keine Sprödphasen bilden, die zur Ablösung der Gleitschicht führen. Es kann daher auf eine Zwischenschicht verzichtet werden, wodurch erhebliche Kosteneinsparungen erzielt werden.

Die Dicke der Trägerschicht liegt vorzugsweise bei 1,2 - 4 mm, vorzugsweise bei 1,3 - 3,5 mm, insbesondere bei 1,4 - 3,0 mm.

Die Dicke der Gleitschicht beträgt vorzugsweise 4 - 30 µm, vorzugsweise 8 - 20 µm, insbesondere 10 - 16 µm

Die Dicke der Einlaufschicht liegt bei 0,2 - 12 µm, vorzugsweise bei 0,2 bis 6 µm, insbesondere bei 0,2 bis 3 µm.

Bevorzugte Verwendungen des Gleitlagerverbundwerkstoffes sind solche für Gleitlagerschalen.

Beispielhafte Kupferlegierungen sind:

**Tabelle 1 (Angaben in Gew.%)**

| Beispiel | 1 | 2 | 3 | 4 | 5 |
|---|---|---|---|---|---|
| Ni | 1,9 | 1,5 | 0,8 | 3,8 | 2,8 |
| Si | 0,6 | 0,5 | 0,25 | 1,2 | 0,8 |
| Mn | 0,15 | 0,05 | 0,05 | 0,1 | 0,05 |
| Pb | <0,1 | <0,1 | <0,1 | <0,1 | <0,1 |
| Cr | | 0,15 | | | 0,15 |
| Ti | | | | 0,15 | |
| Zr | | | 0,2 | | 0,15 |
| Cu | Rest | Rest | Rest | Rest | Rest |

Ein beispielhaftes Verfahren sieht folgende Verfahrensschritte vor:
- Stranggießen einer Kupferlegierung, beispielsweise Doppelstranggießen, mit einer Breite von 300 mm und einer Dicke von 10 mm zur Herstellung von Bandmaterial
- Beidseitiges Fräsen und anschließendes Aufwickeln des Bandmaterials.

Es folgt dann ein erster Glühschritt in einem Haubenofen bei 650°C über 4 Stunden. Im Anschluss daran wird ein erstes Walzen mit 3 Walzschritten durchgeführt. In allen drei Walzschritten wird eine Umformung von 31 % vorgenommen, wobei im ersten Walzschritt die Dicke auf 5,5 mm, im zweiten Walzschritt auf 3,8 mm und im dritten Walzschritt auf 2,6 mm durchgeführt wird.

In einer Bandglühanlage wird anschließend das Band bei 650 °C mit einer Vorlaufgeschwindigkeit von 4m/min geglüht. Hieran schließt sich ein zweites Walzen mit einem Walzschritt an mit einem Umformgrad von 40 %, wobei die Dicke auf 1,56 mm reduziert wird. Anschließend erfolgt ein Längsteilen mit Abmessungen von 95 mm Breite x 1,56 mm Dicke.

Beispiele für Sputter-Schichten sind in der Tabelle 2 zusammengefasst.

**Tabelle 2 (angaben in Gew.%)**

| Beispiel | 1 | 2 | 3 | 4 | 5 |
|---|---|---|---|---|---|
| Al | Rest | Rest | Rest | Rest | Rest |
| Sn | 22 | 35 | 25 | 10 | 20 |
| Cu | 0,7 | 1,2 | 0,7 | 0,5 | 0,5 |
| Si | | | 2,5 | | 1,5 |
| Mn | | | | 1,5 | |
| Ni | | | | 0,7 | 0,7 |

Alle genannten Gleitschichten können mit Trägerschichten aus den Kupferlegierungen kombiniert werden.

Als Einlaufschichten auf diesen Schichtkombinationen können reine Zinn- oder Indium-Schichten, sowie alle genannten Galvanik- und Kunststoffschichten eingesetzt werden, wobei die Einlaufschicht vorzugsweise weicher als die eingesetzte Gleitschicht zu wählen ist.

## Patentansprüche

1. Gleitlagerverbundwerkstoff mit einer Trägerschicht aufweisend eine Kupferlegierung aus 0,5 - 5 Gew.% Nickel, 0,2 - 2,5 Gew.% Silizium, ≤0,1 Gew.% Blei, wahlweise zusätzlich mit 0,05 bis 2 Gew.-% Mangan und/oder 0,05 bis 0,4 Gew.-% Mikrolegierungselementen und Rest Kupfer und mit einer unmittelbar auf der Trägerschicht mittels eines PVD-Verfahrens aufgebrachten Gleitschicht.

2. Gleitlagerverbundwerkstoff nach Anspruch 1, **dadurch gekennzeichnet, dass** die Kupferlegierung 0,05 - 2 Gew.% Mangan aufweist.

3. Gleitlagerverbundwerkstoff nach Anspruch 1 oder 2, **dadurch gekennzeichnet, dass** das Gewichtsverhältnis von Nickel zu Silizium zwischen 2,5 und 5 liegt.

4. Gleitlagerverbundwerkstoff nach einem der Ansprüche 1 bis 3, **dadurch gekennzeichnet, dass** die Trägerschicht 0,05 - 0,4 Gew.% Mikrolegierungselemente aufweist.

5. Gleitlagerverbundwerkstoff nach Anspruch 4, **dadurch gekennzeichnet, dass** die Mikrolegierungselemente Chrom, Titan, Zirkon, Zink, Magnesium und/oder Mangan sind.

6. Gleitlagerverbundwerkstoff nach einem der Ansprüche 1 bis 5, **dadurch gekennzeichnet, dass** die Gleitschicht mittels Sputtern aufgebracht ist.

7. Gleitlagerverbundwerkstoff nach Anspruch 6, **dadurch gekennzeichnet, dass** die Sputter-Schicht aus einer Aluminium-Zinn-Legierung, Aluminium-Zinn-Silizium-Legierung, Aluminium-Zinn-Kupfer-Legierung, einer Aluminium-Zinn-Silizium-Kupfer-Legierung oder einer Aluminium-Zinn-Nickel-Mangan-Legierung besteht.

8. Gleitlagerverbundwerkstoff nach Anspruch 7, **dadurch gekennzeichnet, dass** in den Legierungen der Zinnanteil 8 - 40 Gew.%, der Kupferanteil 0,5 - 4,0 Gew.%, der Siliziumanteil 0,02 - 5,0 Gew.%, der Nickelanteil 0,02 - 2,0 Gew.% und der Mangananteil 0,02 - 2,5 Gew.% beträgt..

9. Gleitlagerverbundwerkstoff nach einem der Ansprüche 1 bis 8, **dadurch gekennzeichnet, dass** auf der Gleitschicht eine Einlaufschicht vorgesehen ist.

10. Gleitlagerverbundwerkstoff nach Anspruch 9, **dadurch gekennzeichnet, dass** die Einlaufschicht als Zinn-, Blei-, Kupfer- oder Indium- oder als Kunststoffschicht ausgeführt ist.

11. Gleitlagerverbundwerkstoff nach einem der Ansprüche 1 bis 10, **dadurch gekennzeichnet, dass** die Dicke der Trägerschicht 1,2 - 4 mm beträgt.

12. Gleitlagerverbundwerkstoff nach einem der Ansprüche 1 bis 11, **dadurch gekennzeichnet, dass** die Dicke der Gleitschicht 4 - 30 µm beträgt.

13. Gleitlagerverbundwerkstoff nach einem der Ansprüche 9 bis 12, **dadurch gekennzeichnet, dass** die Dicke der Einlaufschicht 0,2 bis 12 µm beträgt.

14. Verwendung eines Gleitlagerverbundwerkstoffes nach Anspruch 1 für Gleitlagerschalen.

15. Verfahren zur Herstellung von Bandmaterial, insbesondere für Gleitlagerelemente, wie Gleitlagerschalen, mit folgenden Verfahrensschritten:
- Herstellen von Bandmaterial aus einer Kupferlegierung gemäß Anspruch 1,
- thermo-mechanische Behandlung des Bandmaterials mit folgenden Schritten:
- mindestens ein erstes Glühen des Bandmaterials bei einer Temperatur größer 500°C für mindestens 3 Stunden
- mindestens ein erstes Walzen des Bandmaterials, wobei ein Umformgrad von mindestens 20 % durchgeführt wird
- mindestens ein zweites Glühen bei einer Temperatur größer 500°C und
- mindestens ein zweites Walzen des Bandmaterials, wobei ein Umformgrad von größer 30 % durchgeführt wird.

16. Verfahren nach Anspruch 15, **dadurch gekennzeichnet, dass** das zweite Glühen kontinuierlich in einer Bandglühanlage mit einer Vorschubgeschwindigkeit von mindestens 3 m/min bei Temperaturen >500°C durchgeführt wird.

17. Verfahren zur Herstellung von Gleitlagerelementen, insbesondere von Gleitlagerschalen, **dadurch gekennzeichnet,**
**dass** ein Bandmaterial nach Anspruch 15 oder 16 hergestellt wird,
**dass** vom Bandmaterial Platinen abgetrennt werden,
**dass** diese Platinen zur Gleitlagerelementen umgeformt werden, und
**dass** eine Gleitschicht aufgesputtert wird.

18. Verfahren nach Anspruch 17, **dadurch gekennzeichnet, dass** nach dem Sputtern der Gleitschicht eine Einlaufschicht aufgebracht wird.

## Claims

1. Composite sliding bearing material having a carrier layer having a copper alloy comprising from 0.5 to 5% by weight of nickel, from 0.2 to 2.5% by weight of silicon, ≤ 0.1% by weight of lead, optionally additionally having from 0.05 to 2% by weight of manganese and/or from 0.05 to 0.4% by weight of micro-alloy elements, and the remainder being copper, and having a sliding layer which is applied directly to the carrier layer by means of a PVD method.

2. Composite sliding bearing material according to claim 1, **characterised in that** the copper alloy has from 0.05 to 2% by weight of manganese.

3. Composite sliding bearing material according to claim 1 or claim 2, **characterised in that** the weight ratio of nickel to silicon is between 2.5 and 5.

4. Composite sliding bearing material according to any one of claims 1 to 3, **characterised in that** the carrier layer has from 0.05 to 0.4% by weight of micro-alloy elements.

5. Composite sliding bearing material according to claim 4, **characterised in that** the micro-alloy elements are chromium, titanium, zirconium, zinc, magnesium and/or manganese.

6. Composite sliding bearing material according to any one of claims 1 to 5, **characterised in that** the sliding layer is applied by means of sputtering.

7. Composite sliding bearing material according to claim 6, **characterised in that** the sputter layer comprises an aluminium/tin alloy, aluminium/tin/silicon alloy, aluminium/tin/copper alloy, an aluminium/tin/silicon/copper alloy or an aluminium/tin/nickel/manganese alloy.

8. Composite sliding bearing material according to claim 7, **characterised in that**, in the alloys, the tin proportion is from 8 to 40% by weight, the copper proportion is from 0.5 to 4.0% by weight, the silicon proportion is from 0.02 to 5.0% by weight, the nickel proportion is from 0.02 to 2.0% by weight and the manganese proportion is from 0.02 to 2.5% by weight.

9. Composite sliding bearing material according to any one of claims 1 to 8, **characterised in that** a run-in layer is provided on the sliding layer.

10. Composite sliding bearing material according to claim 9, **characterised in that** the run-in layer is constructed as a layer of tin, lead, copper or indium or as a layer of plastics material.

11. Composite sliding bearing material according to any one of claims 1 to 10, **characterised in that** the thickness of the carrier layer is from 1.2 to 4mm.

12. Composite sliding bearing material according to any one of claims 1 to 11, **characterised in that** the thickness of the sliding layer is from 4 to 30 µm.

13. Composite sliding bearing material according to any one of claims 9 to 12, **characterised in that** the thickness of the run-in layer is from 0.2 to 12 µm.

14. Use of a composite sliding bearing material according to claim 1 for sliding bearing shells.

15. Method for producing strip material, in particular for sliding bearing elements, such as sliding bearing shells, having the following method steps of:
- producing strip material from a copper alloy according to claim 1,
- thermomechanically processing the strip material with the following steps of:
- at least first annealing of the strip material at a temperature greater than 500°C for at least three hours,
- at least first rolling of the strip material, with a shaping degree of at least 20% being carried out,
- at least second annealing at a temperature greater than 500°C and
- at least second rolling of the strip material, with a shaping degree greater than 30% being carried out.

16. Method according to claim 15, **characterised in that** the second annealing operation is carried out continuously in a strip annealing installation at an advance speed of at least 3m/min at temperatures > 500°C.

17. Method for producing sliding bearing elements, in particular sliding bearing shells, **characterised in that** a strip material according to claim 15 or claim 16 is produced,
**in that** plates are separated from the strip material, **in that** those plates are shaped to form sliding bearing elements and
**in that** a sliding layer is sputtered on.

18. Method according to claim 17, **characterised in that** a run-in layer is applied after the sliding layer has been sputtered.

## Revendications

1. Matériau composite pour paliers lisses avec une couche support présentant un alliage de cuivre composé de 0,5 à 5 % en poids de nickel, 0,2 à 2,5 % en poids de silicium, ≤ 0,1 % en poids de plomb, au choix en plus de 0,05 à 2 % en poids de manganèse et/ou de 0,05 à 0,4 % en poids d'éléments de micro-alliage et pour le reste de cuivre, et avec une couche de glissement appliquée directement sur la couche support au moyen d'un procédé de PVD.

2. Matériau composite pour paliers lisses selon la revendication 1, **caractérisé en ce que** l'alliage de cuivre présente 0,05 à 2 % en poids de manganèse.

3. Matériau composite pour paliers lisses selon la revendication 1 ou 2, **caractérisé en ce que** le rapport de poids entre le nickel et le silicium est compris entre 2,5 et 5.

4. Matériau composite pour paliers lisses selon une des revendications 1 à 3, **caractérisé en ce que** la couche support présente 0,05 à 0,4 % en poids d'éléments de micro-alliage.

5. Matériau composite pour paliers lisses selon la revendication 4, **caractérisé en ce que** les éléments de micro-alliage sont du chrome, du titane, du zircon, du zinc, du magnésium et/ou du manganèse.

6. Matériau composite pour paliers lisses selon une des revendications 1 à 5, **caractérisé en ce que** la couche de glissement est appliquée par projection.

7. Matériau composite pour paliers lisses selon la revendication 6, **caractérisé en ce que** la couche projetée est composée d'un alliage aluminium-étain, d'un alliage aluminium-étain-silicium, d'un alliage aluminium-étain-cuivre, d'un alliage aluminium-étain-silicium-cuivre ou d'un alliage aluminium-étain-nickel-manganèse.

8. Matériau composite pour paliers lisses selon la revendication 7, **caractérisé en ce que** dans les alliages la proportion d'étain est de 8 à 40 % en poids, la proportion de cuivre de 0,5 à 4,0 % en poids, la proportion de silicium de 0,02 à 5,0 % en poids, la proportion de nickel de 0,02 à 2,0 % en poids et la proportion de manganèse de 0,02 à 2,5 % en poids.

9. Matériau composite pour paliers lisses selon une des revendications 1 à 8, **caractérisé en ce qu'**une couche de rodage est prévue sur la couche de glissement.

10. Matériau composite pour paliers lisses selon la revendication 9, **caractérisé en ce que** la couche de rodage est réalisée sous forme de couche en étain, plomb, cuivre ou indium ou sous forme de couche en matière plastique.

11. Matériau composite pour paliers lisses selon une des revendications 1 à 10, **caractérisé en ce que** la couche support a une épaisseur de 1,2 à 4 mm.

12. Matériau composite pour paliers lisses selon une des revendications 1 à 11, **caractérisé en ce que** la couche de glissement a une épaisseur de 4 à 30 µm.

13. Matériau composite pour paliers lisses selon une des revendications 9 à 12, **caractérisé en ce que** la couche de rodage a une épaisseur de 0,2 à 12 µm.

14. Utilisation d'un matériau composite pour paliers lisses selon la revendication 1 pour des coussinets de paliers lisses.

15. Procédé de fabrication de matériau en bande, en particulier pour des éléments de paliers lisses, comme des coussinets de paliers lisses, présentant les étapes de procédé suivantes :
- fabrication de matériau en bande dans un alliage de cuivre selon la revendication 1,
- traitement thermomécanique du matériau en bande comportant les étapes suivantes :
- au moins un premier recuit du matériau en bande à une température supérieure à 500 °C pendant au moins 3 heures
- au moins un premier laminage du matériau en bande, avec un degré de déformation d'au moins 20 %
- au moins un deuxième recuit à une température supérieure à 500 °C et
- au moins un deuxième laminage du matériau en bande, avec un degré de déformation supérieur à 30 %.

16. Procédé selon la revendication 15, **caractérisé en ce que** le deuxième recuit est effectué en continu sur une ligne de recuit continu avec une vitesse d'avance d'au moins 3 m/min à des températures > 500 °C.

17. Procédé de fabrication d'éléments de paliers lisses, en particulier de coussinets de paliers lisses, **caractérisé en ce**
**qu'**un matériau en bande selon la revendication 15 ou 16 est fabriqué,
**que** des platines sont détachées du matériau en bande,
**que** ces platines sont formées en éléments de paliers lisses et
**qu'**une couche de glissement est projetée sur ceux-ci.

18. Procédé selon la revendication 17, **caractérisé en ce qu'**après la projection de la couche de glissement, une couche de rodage est appliquée.
